(19) **Europäisches Patentamt European Patent Office Office européen des brevets**

(11) **EP 1 253 756 B1**

(12) **FASCICULE DE BREVET EUROPEEN**

(45) Date de publication et mention de la délivrance du brevet:
**10.01.2018 Bulletin 2018/02**

(51) Int Cl.:
*H04L 27/12* (2006.01)   *H04L 27/20* (2006.01)
*H04B 1/04* (2006.01)

(21) Numéro de dépôt: **02291001.2**

(22) Date de dépôt: **19.04.2002**

(54) **Procédé de multiplication de fréquence dans un équipement de radiocommunication**

Verfahren zur Frequenzmultiplikation in einem Funkkommunikationssystem

Method of frequency multiplication in a radio communication system

(84) Etats contractants désignés:
**AT BE CH CY DE DK ES FI FR GB GR IE IT LI LU MC NL PT SE TR**

(30) Priorité: **27.04.2001 FR 0105729**

(43) Date de publication de la demande:
**30.10.2002 Bulletin 2002/44**

(73) Titulaire: **Thales**
**92400 Courbevoie (FR)**

(72) Inventeurs:
• **Teillet, Hervé,**
**94117 Arcueil Cedex (FR)**
• **Boutigny, Pierre-Henri,**
**94117 Arcueil Cedex (FR)**

(74) Mandataire: **Dudouit, Isabelle**
**Marks & Clerk France**
**Conseils en Propriété Industrielle**
**Immeuble " Visium "**
**22, avenue Aristide Briand**
**94117 Arcueil Cedex (FR)**

(56) Documents cités:
**US-A- 4 355 404    US-A- 5 309 479**
**US-A- 5 903 609**

## Description

La présente invention concerne un équipement de radiocommunication comportant des moyens adaptés à appliquer un coefficient N à un signal ou aux signaux utiles émis par l'équipement.

Elle s'applique dans le cas d'une multiplication de la fréquence du signal par un coefficient N.

L'expression « signal utile » désigne dans la suite de la description un signal porteur de l'information.

L'invention est utilisée dans le cas d'une modulation en phase et/ou d'une modulation en fréquence du signal utile.

Elle concerne, par exemple, les équipements de radiocommunications (faisceaux hertziens, liaisons point à point, liaisons point-multipoint, .....) fonctionnant en bande de fréquences millimétriques.

Dans les équipements de radiocommunication, la chaîne d'émission comporte généralement un dispositif permettant de transposer la fréquence du signal utile porteur de l'information en bande radiofréquence. La fréquence $F_{ol}$ de l'oscillateur local se trouve donc être du même ordre de grandeur que la fréquence d'émission $F_e$. Ceci implique le développement de fonctions dans des gammes de fréquences élevées qui sont difficiles à réaliser notamment dans le domaine millimétrique.

Il est aussi connu des chaînes d'émission où l'étape de multiplication en fréquence est effectuée sur le signal de transposition en fréquence.

Le brevet US 5903609 décrit un système de transmission pour transmettre des symboles numériques par modulation en fonction d'une constellation de phase comprend un émetteur ayant un modulateur de phase et un multiplicateur de fréquence en cascade pour produire un signal modulé ayant une fréquence de transmission désirée. Pour éviter une dégradation du taux d'erreur binaire d'un tel signal, la constellation de phase à l'entrée du modulateur de phase comporte un état de phase supplémentaire par rapport à la constellation de phase à la sortie du multiplicateur de fréquence. La constellation avant multiplication correspond toujours à des états de phase divisés par N.

Le brevet US 5309479 décrit une chaîne émettrice comportant un multiplicateur de fréquence disposée après le mélangeur et l'oscillateur.

Dans le brevet US 4355404 l'information est modulée par une modulation PSK ayant N états discrets, la première fonction étant modulée par N et la deuxième fonction est divisée par N.

L'idée de l'invention repose sur une nouvelle approche où le coefficient N est appliqué sur le ou les signaux utiles émis par un équipement de radiocommunication comme défini par la revendication 1.

L'objet de l'invention concerne un équipement radiofréquence comportant au moins un émetteur et un récepteur d'un ou de plusieurs signaux utiles $S_0$, ledit équipement comporte au moins :

- Une entrée pour recevoir au moins un signal $S'_0$,
- Un dispositif de multiplication adapté à appliquer un coefficient N au signal ou aux signaux utiles pour obtenir un signal $S_4$ à une fréquence de transmission $F_e$,
- Un dispositif de modulation adapté à moduler en phase le ou les signaux utiles de fréquence $F_m$,
- Au moins un dispositif de transposition en fréquence,
- Un dispositif adapté à mélanger le signal utile modulé en fréquence $F_m$ et la fréquence de transposition $F_{ol}$ afin d'obtenir un signal $S_3$ à une fréquence $F_r$ égale à $F_{ol}+F_m$, caractérisé en ce que
- Le dispositif de multiplication est disposé après le dispositif de modulation,
- La modulation est une modulation en phase et le coefficient N de multiplication est un nombre impair, supérieur ou égal à m-1, où m est le nombre d'états de la modulation.

L'équipement est utilisé par exemple dans le domaine des fréquences supérieures à 10 GHz et de préférence supérieures à 25 GHz.

L'invention concerne aussi un procédé d'émission comme défini par la revendication 6.

L'invention offre notamment les avantages suivants :

- une architecture simplifiée de la partie haute fréquence d'une chaîne d'émission,
- l'utilisation d'un minimum de composants dans la partie radiofréquence de l'émetteur, par exemple,
- la réduction du nombre de puces dans le cas d'une application en bande millimétrique. Les puces millimétriques sont d'un coût élevé et d'une mise en place technologique difficile,
- une intégration réduite.

D'autres avantages et caractéristiques de l'invention apparaîtront mieux à la lecture de la description qui suit donnée à titre illustratif et nullement limitatif en relation aux figures qui représentent :

- La figure 1 un schéma d'une chaîne d'émission selon l'invention,

- La figure 2 une variante de la chaîne d'émission de la figure 1 incluant un diviseur de fréquence,
- La figure 3 une variante de la chaîne d'émission de la figure 1 intégrant un diviseur de phase,
- La figure 4 un exemple chiffré de mise en oeuvre de l'invention.

De manière à mieux faire comprendre l'objet de l'invention, la description qui suit, donnée à titre illustratif et nullement limitatif, concerne une chaîne d'émission d'un équipement radiofréquence intégrant un dispositif adapté à multiplier par un coefficient N le ou les signaux utiles $S_0$ émis.

Sans sortir du cadre de l'invention, le coefficient pourrait être un coefficient de division conduisant à un résultat identique à celui obtenu avec le coefficient de multiplication.

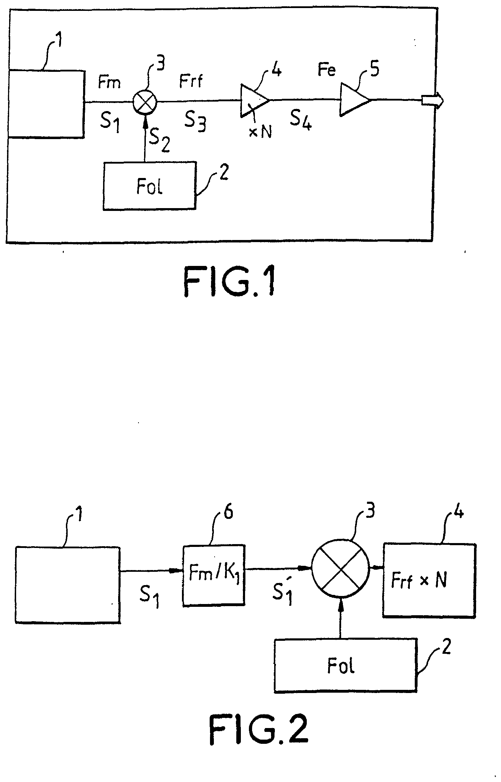

La figure 1 représente un exemple d'une chaîne d'émission d'un équipement radiofréquence.

Elle comporte un modulateur 1 fournissant un signal utile $S_1$ porteur de l'information, modulé en phase et de fréquence $F_m$, un oscillateur local 2 à une fréquence $F_{ol}$, un mélangeur 3 recevant le signal utile modulé et un signal $S_2$ à la fréquence $F_{ol}$ afin de les mélanger et produire un signal $S_3$ à une fréquence $F_r$ égale à $F_m + F_{ol}$. Ce signal $S_3$ transposé en fréquence est envoyé vers un dispositif 4 adapté à le multiplier par un coefficient N de façon à produire un signal $S_4$ à la fréquence d'émission $F_e$, ($F_e = N(F_{ol} + F_m)$). Le signal multiplié est ensuite transmis à un amplificateur 5 permettant de lui donner la puissance suffisante pour son émission.

La multiplication par N du signal $S_3$ de fréquence $F_r$ et de phase initiale $\Phi_r$ génère une fréquence d'émission $F_e = N.F_r$ et une rotation de phase $N.\Phi_r$.

Le principe du fonctionnement de la chaîne d'émission dans le cas d'une modulation de phase est décrit ci-après.

En sortie du modulateur 1, le signal $S_1$ de fréquence $F_m$ est modulé par des sauts de phase correspondant aux données ou bits représentatifs de l'information à transmettre. La lettre m désigne le nombre d'états et dépend de la modulation de phase utilisée.

a) Pour une modulation de type BPSK (abrégé anglo-saxon de Binary Phase Shift Key), la porteuse modulée peut se mettre sous la forme :

$$S_1(t) = A \times V(kT_s)\cos(2\pi F_m t + \phi(t))$$

avec

- A, une constante correspondant à l'amplitude du ou des signaux,
- $V(kT_s) = +/-V$ dans l'intervalle de temps $[kT_s,(k+1)T_s]$, où $V(kT_s)$ représente la valeur des bits qui codent l'information, $T_s$ le temps symbole, avec $T_s = r*T_b$ où $T_b$ est la durée d'un bit et r le nombre de bits permettant de coder une information. La valeur de r est fonction de la modulation utilisée, par exemple r=1 en BPSK.

Les phases ou les sauts de phase valent :

$$i \times 2\pi\, m \text{ pour } i \in [0,...m-1].$$

En modulation BPSK, m = 2 et deux états de phase 0 et $\pi$ sont ainsi obtenus.

b) Pour une modulation QPSK (Quadrature Phase Shift keying), la porteuse modulée $S_1(t)$ s'exprime selon l'expression :

$$S_1(t) = VI(kT_s)A\cos(2\pi F_m t) + VQ(kT_s)A\sin(2\pi F_m t) =$$

$$1.41AV\cos(2\pi F_m t - \phi(k))$$

Il existe alors deux choix possibles pour les valeurs de VI et de VQ dans l'intervalle de temps $[kT_s, (k+1)T_s]$ :

**1er cas :** $VI(kT_s) = +/-V$ et $VQ(kT_s) = +/-V$
**2ème cas :** $(VI(kT_s), VQ(kT_s) = [(V,0), (-V,0), (0,V), (0,-V)]$ où

- $VI(kT_s)$ et $VQ(kT_s)$ représentent la valeur des bits qui codent l'information,

- $T_s$ le temps symbole, avec $T_s = r*T_b$ où $T_b$ est la durée d'un bit et r le nombre de bits permettant de coder une information, la valeur de r est fonction de la modulation utilisée, par exemple r=2 en QPSK.

Les phases ou les sauts de phase correspondants valent :

- dans le **1er cas**, $\pm (2i + 1) \times \pi / m$ pour i $\in$ [0,...(m/2)-1] avec m=4 en QPSK ce qui conduit à quatre états de phase +/-($\pi$/4) et +/-($3\pi$/4) et
- dans **le 2ième cas**, $i\, 2\pi / m$ pour i $\in$ [0,...m-1], ce qui conduit à quatre états de phase 0, $\pi$/2, $\pi$, $3\pi$/2 pour la modulation QPSK.

Le coefficient m représentatif du nombre d'états de phase pour une modulation donnée est m=$2^r$, la valeur du coefficient r dépend de la modulation utilisée.

Par exemple, pour la modulation BPSK (abrégé anglo-saxon de Bit Phase Shift keying) r=1 et m=2, pour la modulation en QPSK (abrégé anglo-saxon de Quadrature Phase Shift Keying) r=2 et m = 4. La valeur du coefficient N de multiplication est choisi par exemple en fonction de l'architecture de la chaîne d'émission et des performances de l'équipement radiofréquence.

Dans le cas d'une modulation de phase QPSK, avec un coefficient N de multiplication en fréquence choisi comme étant un nombre impair ayant une valeur supérieure ou égale à (m-1), les sauts de phase à l'origine $i\times 2\pi / m$ ou $\pm(2i+1)\times \pi / m$ deviennent respectivement des sauts de phase de $N[i\times 2\pi/ m]$ ou $N[\pm(2i+1)\times \pi / m]$.

Dans cet exemple, tous les états de phase modulo 2 $\pi$ sont retrouvés.

La figure 2 schématise une première variante de réalisation du dispositif décrit à la figure 1 permettant notamment d'améliorer les performances spectrales du signal obtenu après multiplication.

Pour cela, la chaîne d'émission comporte en plus des éléments décrits à la figure 1, un diviseur 6 de fréquence disposé avant le mélangeur 3. Ce diviseur divise le signal utile modulé $S_1$ de fréquence $F_m$ par un coefficient $K_1$, afin d'obtenir un signal $S'_1$ de fréquence $F_m/K_1$ avant d'effectuer l'opération de transposition en fréquence à l'aide de la fréquence $F_{ol}$ de l'oscillateur local 2.

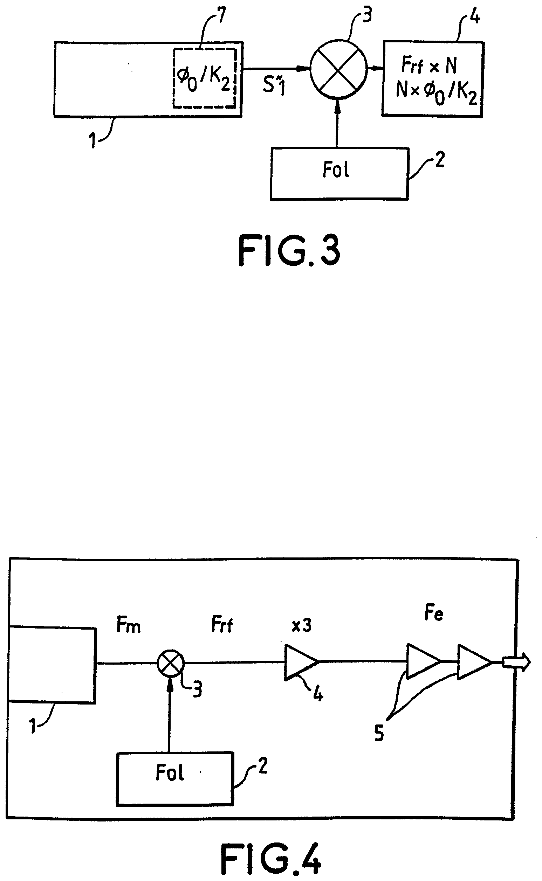

La figure 3 schématise une deuxième variante de réalisation où la chaîne d'émission comporte un diviseur 7 de phase ayant un coefficient de division $K_2$. Ce diviseur est par exemple intégré dans le modulateur 1. Sans sortir du cadre de l'invention, le diviseur peut se trouver à l'extérieur du modulateur.

Le modulateur 1 produit un signal $S''_1$ dont la phase $\Phi$ est divisée par un coefficient $K_2$ ce qui conduit à $\Phi/K_2$. Ce signal est ensuite transmis au mélangeur pour être transposé en fréquence à l'aide de la fréquence $F_{ol}$ selon le schéma décrit en relation avec la figure 1 par exemple.

Les valeurs des coefficients $K_1$ et $K_2$ sont choisies par exemple selon des critères semblables à ceux utilisés pour le choix du coefficient de multiplication N.

Le fait de diviser offre notamment la possibilité:

- de multiplier par un coefficient N quelconque, choisi en respectant les critères précités sans restriction de condition afin de retrouver tous les états de phase modulo 2 $\pi$, le coefficient de division étant alors égal au nombre N,
- de pouvoir filtrer après division dans une bande passante plus étroite, de l'ordre du débit (pour un débit de 4 Mbits, la bande nécessaire est au minimum de l'ordre de 4 M Hz, c'est la bande de base). Il n'est en effet pas possible de filtrer après multiplication le signal portant l'information dans une bande inférieure à N *(bande de base) sans détériorer la qualité de transmission.

La figure 4 représente un exemple chiffré de mise en oeuvre de l'invention.

Le modulateur de phase 1 génère une fréquence $F_m$ à 1 GHz modulée par des sauts de phase correspondants aux données. Les sauts de phase ne sont pas filtrés et le signal modulé obtenu est un signal modulé à enveloppe constante.

Le signal $F_m$ est ensuite transposé par l'oscillateur local à 12.5 GHz afin d'obtenir un signal dont la fréquence $F_r$ est égale à 13.5 GHz. Le signal est ensuite multiplié par 3 en utilisant un amplificateur multiplicateur de fréquence par 3 avant d'être transmis à un ensemble d'amplificateurs 5 afin de lui donner la puissance d'émission voulue.

La modulation à enveloppe constante permet notamment de saturer de la chaîne d'émission sans détériorer les performances de transmission.

Le choix pour la valeur de N est par exemple fonction de la modulation.

En modulation BPSK, les sauts de phase 0/$\pi$ d'origine deviennent des sauts de phase 0/$3\pi$, ce qui donne encore 0/$\pi$ (modulo $2\pi$).

En modulation QPSK, les sauts de phase 0, $\pi$/2, $\pi$, $3\pi$/2, deviennent des sauts de phase 0, $3\pi$/2, $3\pi$ et $9\pi$/2 soit 0, $\pi$/2, $\pi$ et $3\pi$/2 (modulo $2\pi$).

Dans les deux exemples précités, les états de phase modulo $2\pi$, sont retrouvés.

Le dispositif décrit ci-dessus s'applique pour toutes les valeurs de fréquence mais se révèle plus particulièrement intéressant dans le cas d'une source pour la fréquence de transposition difficile à réaliser ou d'un coût élevé. Ceci correspond à des fréquences RF (Radio Fréquence) et OL (oscillateur local) élevées.

L'exemple donné ci-dessus met en oeuvre une modulation de phase, mais peut, sans sortir du cadre de l'invention, être utilisé pour une modulation en fréquence.

Bien que le principe mis en oeuvre dans la présente invention ait été donné pour une chaîne d'émission, l'invention s'applique aussi pour une chaîne de réception d'un équipement radiofréquence.

De même, toute modulation autre que la modulation BPSK, QPSK précitées conservant une enveloppe constante peuvent être utilisées dans le cadre de la présente invention.

## Revendications

**1.** - Equipement radiofréquence comportant au moins un émetteur et un récepteur d'un ou de plusieurs signaux utiles $S_0$, ledit équipement comporte au moins :

• Une entrée pour recevoir au moins un signal $S'_0$,
• Au moins un dispositif (4) de multiplication adapté à appliquer un coefficient N au signal ou aux signaux utiles $S_0$ pour obtenir un signal $S_4$ à une fréquence de transmission $F_e$,
• Un dispositif de modulation (1) adapté à moduler en phase le ou les signaux utiles de fréquence $F_m$,
• Au moins un dispositif (2) de transposition en fréquence,
• Un dispositif (3) pour mélanger le signal utile $S_1$ modulé avec la fréquence $F_m$ et la fréquence de transposition $F_{ol}$ afin d'obtenir un signal $S_3$ à une fréquence $F_r$ égale à $F_{ol}+F_m$, **caractérisé en ce que**
• Le dispositif de multiplication (4) est disposé après ledit dispositif de modulation (1)
• La modulation est une modulation en phase et le coefficient N de multiplication est un nombre impair, supérieur ou égal à m-1, où m est le nombre d'états de la modulation.

**2.** - Equipement selon la revendication 1 **caractérisé en ce qu'**il comporte un dispositif (6) de division en fréquence par un coefficient $K_1$ disposé avant le dispositif de multiplication (4).

**3.** - Equipement selon la revendication 1 **caractérisé en ce qu'**il comporte un dispositif (7) de division en phase par un coefficient $K_2$ avant le dispositif de multiplication (4).

**4.** - Equipement selon l'une des revendications 1 ou 3 **caractérisé en ce que** la modulation en phase est une modulation de type BPSK ou QPSK.

**5.** - Utilisation de l'équipement selon l'une des revendications 1 à 4 dans le domaine des fréquences supérieures à 10 GHz et de préférence supérieures à 25 GHz.

**6.** - Procédé utilisé dans un équipement d'émission et de réception d'un ou de plusieurs signaux utiles $S_0$, ledit procédé comporte au moins une étape où un coefficient N est appliqué au signal ou aux signaux utiles et en ce qu'il comporte au moins les étapes suivantes :

• moduler en phase ou en fréquence le ou les signaux utiles $S_0$ de fréquence $F_m$,
• transposer le signal modulé $S_1$ à une fréquence $F_m+F_{ol}$, avec $F_{ol}$ la fréquence de transposition,
• multiplier le signal modulé transposé $S_3$ par un coefficient N afin d'obtenir un signal $S_4$ à une fréquence d'émission $F_e$, **caractérisé en ce que** le signal utile est modulé en phase et le coefficient N est un nombre impair, ayant une valeur supérieure ou égale à m-1, où m est le nombre d'états de phase de la modulation.

**7.** - Procédé selon la revendication 6 **caractérisé en ce que** la modulation est une modulation de type BPSK ou QPSK.

## Patentansprüche

**1.** Funkfrequenzausrüstung, die mindestens einen Sender und einen Empfänger von einem oder mehreren Nutzsignalen $S_0$ aufweist, wobei die Ausrüstung mindestens aufweist:

• einen Eingang zum Empfangen von mindestens einem Signal $S'_0$,

• mindestens eine Multiplikationsvorrichtung (4), die angepasst ist, einen Koeffizienten N auf das Nutzsignal oder die Nutzsignale $S_0$ anzuwenden, um ein Signal $S_4$ mit einer Übertragungsfrequenz $F_e$ zu erhalten,

• eine Modulationsvorrichtung (1), die angepasst ist, um eine Phasenmodulation des oder der Nutzsignale mit einer Frequenz $F_m$ vorzunehmen,

• mindestens eine Frequenzumsetzungsvorrichtung (2),

• eine Vorrichtung (3) zum Mischen des modulierten Nutzsignals $S_1$ mit der Frequenz $F_m$ und der Umsetzungsfrequenz $F_{ol}$, um ein Signal $S_3$ mit einer Frequenz $F_r$ gleich $F_{ol}+F_m$ zu erhalten, **dadurch gekennzeichnet, dass**

• die Multiplikationsvorrichtung (4) nach der Modulationsvorrichtung (1) angeordnet ist,

• die Modulation eine Phasenmodulation ist und der Multiplikationskoeffizient N eine ungerade Zahl ist, die größer oder gleich m-1 ist, wobei m die Anzahl der Modulationszustände ist

2. Ausrüstung nach Anspruch 1, **dadurch gekennzeichnet, dass** sie eine Vorrichtung (6) zur Frequenzteilung durch einen Koeffizienten $K_1$ aufweist, die vor der Multiplikationsvorrichtung (4) angeordnet ist.

3. Ausrüstung nach Anspruch 1, **dadurch gekennzeichnet, dass** sie eine Vorrichtung (7) zur Frequenzteilung durch einen Koeffizienten $K_2$ vor der Multiplikationsvorrichtung (4) aufweist.

4. Ausrüstung nach einem der Ansprüche 1 oder 3, **dadurch gekennzeichnet, dass** die Phasenmodulation eine Modulation des Typs BPSK oder QPSK ist.

5. Verwendung der Ausrüstung nach einem der Ansprüche 1 bis 4 im Bereich der Frequenzen, die höher als 10 GHz und bevorzugt höher als 25 GHz sind.

6. Verfahren, das in einer Ausrüstung zum Senden und Empfangen von einem oder von mehreren Nutzsignalen $S_0$ verwendet wird, wobei das Verfahren mindestens einen Schritt aufweist, in dem ein Koeffizient N auf das Nutzsignal oder die Nutzsignale angewendet wird, und das mindestens die folgenden Schritte aufweist:

• Phasenmodulation oder Frequenzmodulation des oder der Nutzsignale $S_0$ mit einer Frequenz $F_m$,

• Umsetzen des modulierten Signals $S_1$ auf eine Frequenz $F_m+F_{ol}$, wobei $F_{ol}$ die Umsetzungsfrequenz ist,

• Multiplizieren des modulierten umgesetzten Signals $S_3$ mit einem Koeffizienten N, um ein Signal $S_4$ mit einer Sendefrequenz $F_e$ zu erhalten, **dadurch gekennzeichnet, dass** das Nutzsignal phasenmoduliert ist und der Koeffizient N eine ungerade Zahl ist, die einen Wert größer oder gleich m-1 hat, wobei m die Anzahl der Phasenzustände der Modulation ist.

7. Verfahren nach Anspruch 6, **dadurch gekennzeichnet, dass** die Modulation eine Modulation des Typs BPSK oder QPSK ist.

## Claims

1. Radiofrequency equipment comprising at least one transmitter and one receiver of one or more useful signals So, said equipment comprising at least:

• one entry for receiving at least one signal $S'_0$;

• at least one multiplier device (4) adapted to the application of a coefficient N to the useful signal or signals $S_0$ in order to obtain a signal $S_4$ at a transmission frequency $F_e$;

• one modulation device (1) adapted to the phase modulation of the useful signal or signals with a frequency $F_m$;

• at least one frequency transposition device (2);

• one device (3) to mix the modulated useful signal $S_1$ at the frequency $F_m$ with the transposition frequency $F_{ol}$ in order to obtain a signal $S_3$ at a frequency $F_r$ that is equal to $F_{ol}+F_m$, **characterised in that**

• the multiplier device (4) is positioned after said modulation device (1);

• the modulation is a phase modulation and the multiplication coefficient N is an odd number greater than or equal to m-1, where m is the number of states of the modulation.

2. Equipment according to claim 1, **characterised in that** it comprises a device (6) for frequency division by a coefficient $K_1$ positioned before the multiplier device (4).

3. Equipment according to claim 1, **characterised in that** it comprises a device (7) for phase division by a coefficient

$K_2$ before the multiplier device (4).

4. Equipment according to any one of claims 1 or 3, **characterised in that** the phase modulation is a BPSK or QPSK type modulation.

5. A use of the equipment according to any one of claims 1 to 4 in the range of frequencies higher than 10 GHz and preferably higher than 25 GHz.

6. A method used in equipment for the transmission and the reception of one or more useful signals $S_0$, said method comprising at least one step in which a coefficient N is applied to the useful signal or signals, wherein the method comprises at least the following steps:

    • the phase or frequency modulation of the useful signal or signals $S_0$ with the frequency $F_m$;
    • the transposition of the modulated signal $S_1$ to a frequency $F_m+F_{ol}$, with $F_{ol}$ being the transposition frequency;
    • the multiplication of the transposed modulated signal $S_3$ by a coefficient N in order to obtain a signal $S_4$ at a transmission frequency $F_e$, **characterised in that** the useful signal is phase modulated and the coefficient N is an odd number having a value higher than or equal to m-1, where m is the number of states of the modulation.

7. A method according to claim 6, **characterised in that** the modulation is a BPSK or QPSK type modulation.

**FIG.1**

**FIG.2**

FIG.3

FIG.4

**EP 1 253 756 B1**

## RÉFÉRENCES CITÉES DANS LA DESCRIPTION

**Documents brevets cités dans la description**

- US 5903609 A
- US 5309479 A
- US 4355404 A